# EUROPEAN PATENT APPLICATION

(11) **EP 4 557 358 A1**
(43) Date of publication of application: **21.05.2025**
(21) Application number: 23839701.2
(22) Date of filing: 14.07.2023
(51) Int. Cl.: H01L 23/13, H01L 23/12, H05K 1/02, H05K 1/03, H01L 25/07, H01L 25/18

(54) **MULTILAYER ASSEMBLY, SEMICONDUCTOR DEVICE USING SAME, AND METHOD FOR MANUFACTURING SAME**

(30) Priority: 15.07.2022 JP 2022114292; 05.07.2023 JP 2023110428
(71) Applicant: Mitsubishi Materials Corporation, Tokyo 100-8117 (JP)
(72) Inventor: KITAHARA, Takeshi, Sunto-gun, Shizuoka 410-1312 (JP); OI, Sotaro, Sunto-gun, Shizuoka 410-1312 (JP); IWATA, Kotaro, Naka-shi, Ibaraki 311-0102 (JP)
(74) Representative: Hoffmann Eitle
(86) International application number: PCT/JP2023/026026
(87) International publication number: WO 2024/014532

(57) **Abstract**

Joining is made at a low temperature and warpage is suppressed in the formation of a multilayer assembly, such as joining of a heat sink to an insulating circuit board. A multilayer assembly including: a ceramic substrate; a first aluminum plate which is joined to one surface of the ceramic substrate and contains aluminum or an aluminum alloy; a first intermediate metal layer which is joined to a surface of the first aluminum plate opposite to the ceramic substrate and contains any of copper, nickel, silver, or gold; a first sintered copper layer which is joined to a surface of the first intermediate metal layer opposite to the first aluminum plate; and a first metal member which is joined to a surface of the first sintered copper layer opposite to the first intermediate metal layer and contains any of aluminum, an aluminum alloy, copper, or a copper alloy.

## Description

### Technical Field

The present invention relates to a multilayer assembly which can be used as an insulating circuit board and in which a metal member containing any of aluminum, an aluminum alloy, copper, or a copper alloy is joined by a copper joining material to an aluminum plate joined to a ceramic substrate, a semiconductor device using the multilayer assembly, and manufacturing methods of the multilayer assembly and the semiconductor device. The present application claims priority based on Japanese Patent Application No. 2022-114292 filed on July 15, 2022 in Japan and Japanese Patent Application No. 2023-110428 filed on July 5, 2023 in Japan, the contents of which are incorporated herein by reference.

### Background Art

Insulating circuit boards on which electronic components such as LEDs and power elements are mounted are provided with a heat sink for dissipating heat generated by the electronic components.

In this case, cases where a ceramic substrate is used as an insulating circuit board are also known, and a circuit layer is formed on one surface of the ceramic substrate serving as an insulating layer, and a heat dissipation layer is formed on the other surface of the ceramic substrate. A heat sink having excellent thermal conductivity is joined to the heat dissipation layer through a brazing material, and an electronic component is mounted on the circuit layer through a solder material to obtain an insulating circuit board with a heat sink.

In such an insulating circuit board with a heat sink, an aluminum plate of the insulating circuit board and the heat sink are joined at a high temperature of 600°C or the like.

### Citation List

### Patent Literature

[Patent Literature 1] JP-A-2020-35965

### Summary of Invention

### Technical Problem

In the related art, in a case where an insulating circuit board and a heat sink are joined at a high temperature, warpage is likely to occur due to a difference in thermal expansion between the heat sink and the ceramic substrate having a low thermal expansion coefficient during cooling. Therefore, it is desirable to join the insulating circuit board and the heat sink at a low temperature. Not only in a case where the heat sink is joined, but also in a case where a copper plate for a circuit layer or the like is joined to one aluminum plate of the insulating circuit board, when the heating temperature is high, warpage may occur due to a difference in thermal expansion during cooling, resulting in a decrease in joinability.

Patent Literature 1 discloses a power module using an insulating circuit board in which copper plates are joined to both surfaces of a ceramic substrate. In the power module, a heat dissipation base plate made of copper or the like is joined to the copper plate of the insulating circuit board with a joining material. In Patent Literature 1, since the copper plates are joined to both surfaces of the insulating substrate made of ceramics, large warpage may occur due to a difference in thermal expansion coefficient, resulting in a decrease in joinability.

Therefore, an object of the present invention is to suppress warpage and improve joinability by performing joining at a low temperature in the formation of a multilayer assembly, such as joining of a heat sink to an insulating circuit board.

### Solution to Problem

### [Multilayer Assembly]

A multilayer assembly according to the present invention includes: a ceramic substrate; a first aluminum plate which is joined to one surface of the ceramic substrate and contains aluminum or an aluminum alloy; a first intermediate metal layer which is joined to a surface of the first aluminum plate opposite to the ceramic substrate and contains any of copper, nickel, silver, or gold; a first sintered copper layer which is joined to a surface of the first intermediate metal layer opposite to the first aluminum plate; and a first metal member which is joined to a surface of the first sintered copper layer opposite to the first intermediate metal layer and contains any of aluminum, an aluminum alloy, copper, or a copper alloy.

In the multilayer assembly according to the present invention, the first metal member may contain aluminum or an aluminum alloy, and a second intermediate metal layer containing any of copper, nickel, silver, or gold may be formed between the first metal member and the first sintered copper layer.

In the multilayer assembly according to the present invention, a second aluminum plate consisting of aluminum or an aluminum alloy may be joined to the other surface of the ceramic substrate.

In the multilayer assembly according to the present invention, a third intermediate metal layer which is joined to a surface of the second aluminum plate opposite to the ceramic substrate and contains any of copper, nickel, silver, or gold; a second sintered copper layer which is joined to a surface of the third intermediate metal layer opposite to the second aluminum plate; and a second metal member which is joined to a surface of the second sintered copper layer opposite to the second aluminum plate and contains any of aluminum, an aluminum alloy, copper, or a copper alloy may be further provided.

In the multilayer assembly according to the present invention, the second metal member may contain aluminum or an aluminum alloy, and a fourth intermediate metal layer containing any of copper, nickel, silver, or gold may be formed between the second metal member and the second sintered copper layer.

In the present invention, the "first metal member containing any of aluminum, an aluminum alloy, copper, or a copper alloy" means that at least the joining surface of the first metal member on the first sintered copper layer side is formed of any of aluminum, an aluminum alloy, copper, or a copper alloy, and the first metal member may be configured as, for example, a composite material or a stacked material. In addition, the "first metal member containing any of aluminum, an aluminum alloy, copper, or a copper alloy" also includes a case where the first metal member is formed of any of aluminum, an aluminum alloy, copper, or a copper alloy.

In the multilayer assembly according to the present invention, the first intermediate metal layer formed on the surface of the first aluminum plate and the first metal member are joined with the first sintered copper layer interposed therebetween. The first sintered copper layer is a sintered copper layer formed by sintering copper particles. The first sintered copper layer may be formed by sintering a copper paste, by sintering a joining sheet formed into a sheet shape with a plurality of copper particles bound by a binder, or by sintering a sintered copper sheet formed into a sheet shape with a part of copper particles sintered.

The first sintered copper layer using a joining sheet is obtained by sintering a sheet-like first joining material with a plurality of copper particles bound by a binder. The first sintered copper layer using a joining sheet is preferable, since it has a smaller binder amount than the first sintered copper layer using a copper paste and the occurrence of voids caused by the volatilization of the organic component during sintering is thus suppressed. In addition, since the first intermediate metal layer is provided, the joinability between the first aluminum plate and the first sintered copper layer is good.

In the present invention, the "first intermediate metal layer containing any of copper, nickel, silver, or gold" means that at least the joining surface of the first intermediate metal layer on the first sintered copper layer side is formed of any of copper, nickel, silver, or gold, and the first intermediate metal layer may be composed of, for example, a plurality of plating layers. In addition, the "first intermediate metal layer containing any of copper, nickel, silver, or gold" also includes a case where the first intermediate metal layer is formed of any of copper, nickel, silver, or gold.

In the multilayer assembly according to the present invention, the second intermediate metal layer is preferably formed between the first metal member and the first sintered copper layer. In a case where the first metal member contains aluminum or an aluminum alloy, the second intermediate metal layer preferably contains any of copper, nickel, silver, or gold.

In the present invention, the "second intermediate metal layer containing any of copper, nickel, silver, or gold" means that at least the joining surface of the second intermediate metal layer on the first sintered copper layer side is formed of any of copper, nickel, silver, or gold, and the second intermediate metal layer may be composed of, for example, a plurality of plating layers. In addition, the "second intermediate metal layer containing any of copper, nickel, silver, or gold" also includes a case where the second intermediate metal layer is formed of any of copper, nickel, silver, or gold.

In a case where the first metal member contains copper or a copper alloy, the second intermediate metal layer preferably does not contain nickel, but may contain nickel.

In the present invention, the phrase that the second intermediate metal layer contains nickel means that at least the joining surface of the second intermediate layer on the first sintered copper layer side is formed of nickel, and the second intermediate metal layer may be composed of, for example, a plurality of plating layers. In addition, the phrase that the second intermediate metal layer contains nickel also includes a case where the second intermediate metal layer is formed of nickel.

Due to the interposition of the first intermediate metal layer, the joinability between the first aluminum plate and the first sintered copper layer can be increased. In addition, since the second intermediate metal layer is formed, the joinability between the first metal member and the first sintered copper layer can be increased.

In the multilayer assembly according to the present invention, the first aluminum plate and the second aluminum plate preferably consist of aluminum having a purity of 99.99% by mass or more.

Since the first aluminum plate and the second aluminum plate are made of soft high-purity aluminum of 4N (purity: 99.99% by mass) or higher specified in Japanese Industrial Standards (JIS), the yield stress is low. Therefore, they can maintain high joining reliability with the ceramic substrate in the temperature cycle, and exhibit high thermal conductivity and high electrical conductivity with the first metal member and the like. The upper limit of the aluminum purity is not limited, and aluminum of 99.999% by mass or so-called 6N aluminum of 99.9999% by mass may be used.

In the multilayer assembly according to the present invention, the sizes of the first aluminum plate, the first sintered copper layer, and the first metal member, in other words, the sizes of the joining surfaces thereof are not limited, but for example, preferably 100 mm² or more and 10,000 mm² or less.

Since the thickness of the first sintered copper layer in the stacking direction is 50 µm or more and 1,000 µm or less, the first aluminum and the first metal member can be favorably joined.

In the multilayer assembly according to the present invention, a plurality of groove portions may be preferably formed on the surface of the first aluminum plate opposite to the ceramic substrate.

Since the groove portions are provided on the surface of the first aluminum plate to be joined to the first metal member, the binder is favorably volatilized during sintering, and voids at a joining portion can be reduced. Therefore, the joinability with the first metal member through the first sintered copper layer is improved. In addition, due to the joining, the unevenness of the groove portions after joining may be smaller than that before joining.

In the multilayer assembly according to the present invention, an insulating circuit board in which the surface of the first metal member is an electronic component mounting surface can be provided.

In a case where a multilayer assembly in which the second aluminum plate is joined to the surface of the ceramic substrate opposite to the first aluminum plate is provided as an insulating circuit board, the surface of the first metal member may be an electronic component mounting surface, or the surface of the second aluminum plate may be an electronic component mounting surface.

In the insulating circuit board, since the first aluminum plate and the second aluminum plate are made of soft high-purity aluminum of 4N or higher, they can maintain high joining reliability with the ceramic substrate in the temperature cycle, and exhibit high thermal conductivity and high electrical conductivity as a whole of the insulating circuit board. The upper limit of the aluminum purity is not limited, and aluminum of 99.999% by mass or so-called 6N aluminum of 99.9999% by mass may be used.

In a case where the multilayer assembly according to the present invention is provided as an insulating circuit board and the surface of the first metal member is an electronic component mounting surface, the second aluminum plate can be used as a heat sink. In a case where the surface of the second aluminum plate is an electronic component mounting surface, the first metal member can be provided as a heat sink.

### [Semiconductor Device]

A semiconductor device can be configured using the multilayer assembly according to the present invention.

A semiconductor device according to the present invention includes: an electronic component which is mounted on a surface of the first metal member opposite to the first sintered copper layer; a lead frame which is connected to the electronic component; and an insulating resin which seals the electronic component in a state in which a tip portion of the lead frame and at least a surface of the second aluminum plate opposite to the ceramic substrate are exposed.

In the semiconductor device according to the present invention, an electronic component which is mounted on a surface of the second aluminum plate opposite to the ceramic substrate; a lead frame which is connected to the electronic component; and an insulating resin which seals the electronic component in a state in which a tip portion of the lead frame and at least a surface of the first metal member excluding a joining surface with the first sintered copper layer are exposed may be provided.

In the semiconductor device using the multilayer assembly provided with a second metal member, an electronic component which is mounted on a surface of the first metal member opposite to the first sintered copper layer; a lead frame which is connected to the electronic component; and an insulating resin which seals the electronic component in a state in which a tip portion of the lead frame and at least a surface of the second metal member excluding a joining surface with the second sintered copper layer are exposed may be provided.

### [Method for Manufacturing Multilayer Assembly]

A method for manufacturing a multilayer assembly according to the present invention includes: a first stacking step of stacking, on one surface of a ceramic substrate, a brazing material and a first aluminum plate containing aluminum or an aluminum alloy to form a first stacked body; a first joining step of achieving joining by pressing and heating the first stacked body in a stacked state to form a first assembly; an intermediate metal layer forming step of forming a first intermediate metal layer containing any of copper, nickel, silver, or gold on a surface of the first aluminum plate of the first assembly opposite to the ceramic substrate; a second stacking step of sequentially stacking, on the first intermediate metal layer, a first joining material formed into a sheet shape with a plurality of copper particles bound by a binder and a first metal member containing any of aluminum, an aluminum alloy, copper, or a copper alloy to form a second stacked body; and a second joining step of sintering the first joining material by heating the second stacked body while pressing the second stacked body in a stacking direction to form a first sintered copper layer, thereby joining the first intermediate metal layer on the first aluminum plate and the first metal member by the first sintered copper layer.

In the method for manufacturing a multilayer assembly according to the present invention, the first metal member may contain aluminum or an aluminum alloy, in the intermediate metal layer forming step, a second intermediate metal layer containing any of copper, nickel, silver, or gold may be further formed on one surface of the first metal member, and in the second joining step, the second intermediate metal layer may be joined to the first sintered copper layer.

By joining the first intermediate metal layer and the first metal member using the first joining material, it is possible to suppress the occurrence of voids caused by heating of the organic component during joining, thereby improving the joinability. The first joining material formed into a sheet shape with a plurality of copper particles bound by a binder may be partially sintered when being formed into a sheet shape.

In the method for manufacturing a multilayer assembly according to the present invention, a plurality of groove portions may be formed on the surface of the first aluminum plate opposite to the ceramic substrate before the first stacking step.

In the method for manufacturing a multilayer assembly according to the present invention, in the first stacking step, a second aluminum plate containing a brazing material and aluminum or an aluminum alloy may be further stacked on the other surface of the ceramic substrate to form the first stacked body, and in the first joining step, by pressing and heating the first stacked body including the second aluminum plate, the first aluminum plate may be joined to the one surface of the ceramic substrate and the second aluminum plate may be joined to the other surface to form the first assembly.

In the method for manufacturing a multilayer assembly according to the present invention, in the intermediate metal layer forming step, a third intermediate metal layer containing any of copper, nickel, silver, or gold may be further formed on a surface of the second aluminum plate of the first assembly opposite to the ceramic substrate, in the second stacking step, a second joining material formed into a sheet shape with a plurality of copper particles bound by a binder and a second metal member containing any of aluminum, an aluminum alloy, copper, or a copper alloy may be sequentially further stacked on the third intermediate metal layer, and in the second joining step, a second sintered copper layer may be further formed by sintering the second joining material to join the third intermediate metal layer and the second metal member by the second sintered copper layer.

In the method for manufacturing a multilayer assembly according to the present invention, the second metal member may contain aluminum or an aluminum alloy, in the intermediate metal layer forming step, a fourth intermediate metal layer containing any of copper, nickel, silver, or gold may be further formed on one surface of the second metal member, and in the second joining step, a surface of the fourth intermediate metal layer on the second metal member may be joined to the second sintered copper layer.

### [Method for Manufacturing Semiconductor Device]

The present invention also provides a method for manufacturing a semiconductor device using the above-described method for manufacturing a multilayer assembly.

A method for manufacturing a semiconductor device according to the present invention is a method for manufacturing a semiconductor device using the above-described method for manufacturing a multilayer assembly, in which after the second joining step, a mounting step of mounting an electronic component on the first metal member and connecting a lead frame to the electronic component, and a resin sealing step of sealing the electronic component with an insulating resin in a state in which a tip portion of the lead frame and at least a surface of the second aluminum opposite to the ceramic substrate are exposed from the insulating resin are further included.

In the method for manufacturing a semiconductor device according to the present invention, between the intermediate layer forming step and the second stacking step, a mounting step of mounting an electronic component on the second aluminum plate and connecting a lead frame to the electronic component, and a resin sealing step of sealing the electronic component with an insulating resin in a state in which a tip portion of the lead frame and at least a surface of the first intermediate metal layer are exposed from the insulating resin may be further included.

In the method for manufacturing a semiconductor device according to the present invention, in the intermediate layer forming step, a third intermediate metal layer containing any of copper, nickel, silver, or gold may be further formed on a surface of the second aluminum plate of the first assembly opposite to the ceramic substrate, and after the second joining step, a mounting step of mounting an electronic component on the first metal member and connecting a lead frame to the electronic component, a resin sealing step of sealing the electronic component with an insulating resin in a state in which a tip portion of the lead frame and at least a surface of the third intermediate metal layer are exposed from the insulating resin, a third stacking step of sequentially further stacking a second joining material formed into a sheet shape with a plurality of copper particles bound by a binder and a second metal member containing any of aluminum, an aluminum alloy, copper, or a copper alloy on the third intermediate metal layer to form a third stacked body, and a third joining step of sintering the second joining material by heating the secondary stacked body while pressing the secondary stacked body in a stacking direction to form a second sintered copper layer, thereby joining the third intermediate metal layer and the second metal member by the second sintered copper layer may be further included.

The third joining step accompanied by pressing and heating is performed after the mounting step and the resin sealing step. However, in the third joining step, the second sintered copper layer is provided for joining at a low temperature, so that it is possible to suppress the thermal influences on the electronic component, the insulating resin, and the like.

### Advantageous Effects of Invention

According to the present invention, in a case where a heat sink is joined to an insulating circuit board, for example, a first metal member can be joined at a low temperature by a sintered copper layer, and thus it is possible to suppress warpage and improve joinability.

### Brief Description of Drawings

[Fig. 1] Fig. 1 is a cross-sectional view showing a multilayer assembly according to an embodiment of the present invention.
[Fig. 2] Fig. 2 is a schematic cross-sectional view of a joining material used for joining of the multilayer assembly.
[Fig. 3] Fig. 3 is a cross-sectional view showing a multilayer assembly according to another embodiment.
[Fig. 4] Fig. 4 is a cross-sectional view showing still another multilayer assembly.
[Fig. 5] Fig. 5 is a flowchart showing a method for manufacturing a multilayer assembly shown in Fig. 4 and a method for manufacturing a semiconductor device thereafter.
[Fig. 6] Fig. 6 is a cross-sectional view showing a first stacking step in the method for manufacturing the multilayer assembly of Fig. 4.
[Fig. 7] Fig. 7 is a plan view of a first aluminum plate in which groove portions are formed.
[Fig. 8] Fig. 8 is a cross-sectional view taken along the line G-G of Fig. 7 and is a partial cross-sectional view of the first aluminum plate having the groove portions.
[Fig. 9] Fig. 9 is a cross-sectional view showing a second stacking step in the method for manufacturing the multilayer assembly shown in Fig. 4.
[Fig. 10] Fig. 10 is a cross-sectional view of a semiconductor device using the multilayer assembly of Fig. 4.
[Fig. 11] Fig. 11 is a cross-sectional view showing a step of performing resin sealing during manufacturing of the semiconductor device of Fig. 10.
[Fig. 12] Fig. 12 is a cross-sectional view showing an example in which a first metal member is a heat sink in the multilayer assembly of Fig. 4.
[Fig. 13] Fig. 13 is a cross-sectional view showing an application example of the multilayer assembly of Fig. 12, in which a first metal member is a heat sink with fins.
[Fig. 14] Fig. 14 is a cross-sectional view showing a semiconductor device using the multilayer assembly of Fig. 13.
[Fig. 15] Fig. 15 is a flowchart showing a method for the manufacturing the semiconductor device shown in Fig. 14.
[Fig. 16] Fig. 16 is a cross-sectional view showing a state in which an intermediate metal layer is formed on a first assembly in the method for manufacturing the semiconductor device shown in Fig. 14.
[Fig. 17] Fig. 17 is a cross-sectional view showing a second stacking step in the method for manufacturing the semiconductor device shown in Fig. 14.
[Fig. 18] Fig. 18 is a cross-sectional view showing an example of a multilayer assembly in which a second metal member is further joined to a second aluminum plate of the multilayer assembly shown in Fig. 4 through a sintered copper layer.
[Fig. 19] Fig. 19 is a cross-sectional view showing a second stacking step in a method for manufacturing the multilayer assembly shown in Fig. 18.
[Fig. 20] Fig. 20 is a cross-sectional view showing an example of a multilayer assembly in which a fourth intermediate metal layer is further formed on the second metal member of the multilayer assembly of Fig. 18.
[Fig. 21] Fig. 21 is a cross-sectional view showing a semiconductor device using the multilayer assembly of Fig. 18.
[Fig. 22] Fig. 22 is a flowchart showing a method for the manufacturing the semiconductor device shown in Fig. 21.
[Fig. 23] Fig. 23 is a cross-sectional view showing a third stacking step in the method for manufacturing the semiconductor device shown in Fig. 21.

### Description of Embodiments

Hereinafter, embodiments of the present invention will be described with reference to the drawings.

### [Configuration of Multilayer Assembly 10]

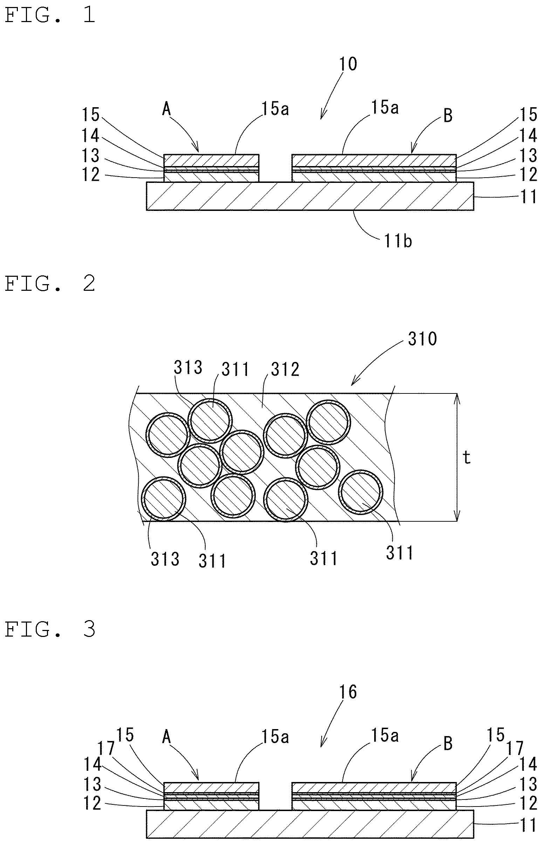

As shown in Fig. 1, a multilayer assembly 10 according to a first embodiment includes a ceramic substrate 11, a first aluminum plate 12 stacked on one surface of the ceramic substrate 11, a first intermediate metal layer 13 joined to a surface of the first aluminum plate 12 opposite to the ceramic substrate 11, a first sintered copper layer 14 joined to a surface of the first intermediate metal layer 13 opposite to the first aluminum plate 12, and a first metal member 15 joined to a surface of the first sintered copper layer 14 opposite to the first intermediate metal layer 13.

In the example shown in Fig. 1, the first aluminum plate 12, the first intermediate metal layer 13, the first sintered copper layer 14, and the first metal member 15 are stacked in a state in which they are separated into a plurality of parts (two parts denoted by reference signs A and B in Fig. 1), and thus stacked parts having the same layer structure, denoted by reference signs A and B, are provided on the ceramic substrate 11. However, one stacked part may be provided without separation. Needless to say, three or more stacked parts may be provided. In addition, since the two stacked parts shown in the drawing differ only in size and have a structure in which the same members are stacked, the reference signs of the members may be attached to only one stacked part denoted by A or B (the same also applies to Fig. 3 and the like).

The ceramic substrate 11 is an insulating material, and is formed of, for example, aluminum nitride (AlN), silicon nitride (Si₃N₄), aluminum oxide (Al₂O₃), or the like. Its plate thickness is, for example, 0.2 mm to 1.2 mm.

For the first aluminum plate 12, pure aluminum having a purity of 99% by mass or more or an aluminum alloy is used, and in the JIS standard, 1000 series pure aluminum, particularly 1N90 (purity of 99.9% by mass or more: so-called 3N aluminum) or 1N99 (purity of 99.99% by mass or more: so-called 4N aluminum) can be used. The thickness thereof is set to, for example, 0.4 mm to 1.6 mm.

The first intermediate metal layer 13 contains any of copper, nickel, silver, or gold, and is formed while being in close contact with a surface of the first aluminum plate 12 by plating or the like. The first aluminum plate 12 and the first sintered copper layer 14 are joined through the first intermediate metal layer 13. In a case where the first intermediate metal layer 13 is made of silver or gold, a nickel coating may be applied to the first aluminum plate 12 as an underlayer, and the first intermediate metal layer 13 may be formed thereon.

The first sintered copper layer 14 joins the first intermediate metal layer 13 and the first metal member 15, and is formed by heating and sintering a first joining material 310 formed into a sheet shape with a plurality of copper particles 311 bound by a binder (solvent) 312. Details thereof will be described later.

The first metal member 15 is formed of, for example, a plate material (copper plate) consisting of copper (oxygen-free copper) having a purity of 99.96% by mass or more, copper (tough pitch copper) having a purity of 99.90% by mass or more, or a copper alloy, or an aluminum plate having a purity of less than 99.90% by mass, such as a pure aluminum plate of so-called 2N aluminum (for example, A1050 or the like) having a purity of 99.0% by mass or more or an aluminum plate consisting of an aluminum alloy such as A3003, A6063, or A5052 in the JIS standard. The thickness of the first metal member 15 is set to, for example, 0.5 mm to 1.5 mm.

### (Details of First Sintered Copper Layer 14)

The first sintered copper layer 14 is formed by pressing and heating the first joining material 310, and for example, "sheet for Joining" described in JP-A-2021-116463 filed by the present applicant can be used. As shown in Fig. 2, the first joining material 310 includes a plurality of copper particles 311 of 90% by mass or more and 99% by mass or less and a solvent 312 of 1% by mass or more and 10% by mass or less.

In this case, the average particle diameter (BET diameter) of the copper particles 311, converted from a specific surface area using a spherical model according to JIS Z 8830, is 50 nm or more and 300 nm or less. The copper particles 311 can be produced as follows: after the pH of an aqueous dispersion of copper citrate is adjusted to (2.0 or more and 7.5 or less), a hydrazine compound is added and mixed under an inert gas atmosphere, the mixed liquid is held (for 1.5 hours or longer and 2.5 hours or shorter) at a predetermined temperature (60°C or higher and 80°C or lower) under an inert gas atmosphere to reduce the eluted copper ions, and thus the copper particles 311 can be produced. In addition, the copper particles 311 are covered with a coating 313 of an organic substance (derived from citric acid), and oxidation thereof is suppressed.

The solvent 312 as a binder which binds the plurality of copper particles 311 has a boiling point of 150°C or higher, and is formed of one of organic solvents or polymer solvents or formed using two or more thereof. For example, a diol compound or a triol compound can be used.

In a case where the first joining material 310 includes the copper particles 311 and the solvent 312, a thickness t of the first joining material 310 is not limited, and may be, for example, 50 µm or more and 1,000 µm or less, or 500 µm or more. The first joining material 310 is not limited to a material formed into a sheet shape in which all of the plurality of copper particles 311 is in an unsintered state, and a material formed into a sheet shape in which a part of the plurality of copper particles 311 is sintered and bound together and the remaining copper particles are in an unsintered state can also be used.

The first joining material 310 is overlapped on the first intermediate metal layer 13, and heated while being pressed in the stacking direction, so that the solvent 312 in the first joining material 310 and the coating 313 around the copper particles 311 volatilize and the copper particles 311 are sintered each other and formed into the first sintered copper layer 14. In the first sintered copper layer 14, any of nickel, copper, gold, or silver, constituting the first intermediate metal layer 13, is contained in an interface region.

The multilayer assembly 10 can be used as an insulating circuit board in which the first aluminum plate 12, the first intermediate metal layer 13, the first sintered copper layer 14, and the first metal member 15 are sequentially joined in a stacked state on the ceramic substrate 11 and a surface 15a of the first metal member 15 is an electronic component mounting surface. In this case, for example, a thermally conductive grease or the like can be applied to a surface 11b of the ceramic substrate 11 opposite to the first aluminum plate 12, and the surface 11b can be brought into contact with a heat sink or the like (not shown) for heat dissipation and fixed by screwing or the like.

### [Configuration of Multilayer Assembly 16]

Fig. 3 shows a case where a metal plate consisting of aluminum or an aluminum alloy is used as the first metal member 15 in the multilayer assembly 10. As in a multilayer assembly 16 shown in Fig. 3, a second intermediate metal layer 17 containing any of copper, nickel, silver, or gold is formed on a surface of a first metal member 15 joined to a first sintered copper layer 14 by plating or the like as in a case of the first intermediate metal layer 13 of the first aluminum plate 12, and the second intermediate metal layer 17 is joined to the first sintered copper layer 14.

In a case where the second intermediate metal layer 17 is made of silver or gold, a nickel coating may be formed on the first metal member 15 as an underlayer, and the second intermediate metal layer 17 may be formed thereon.

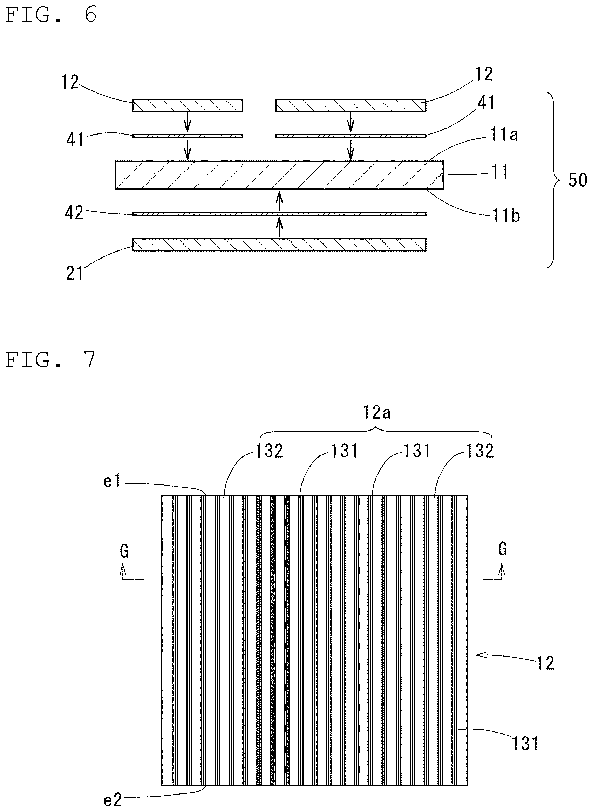

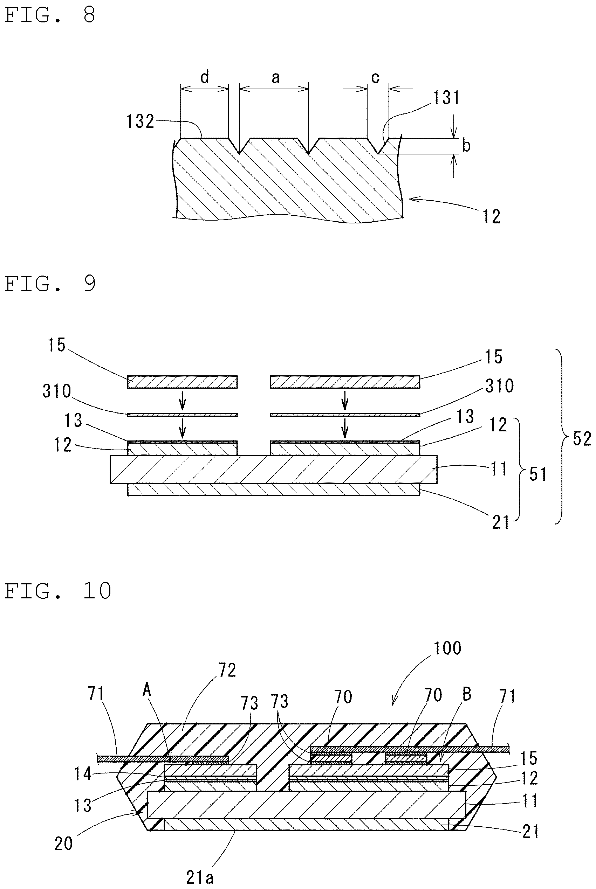

In these multilayer assemblies 10 and 16, groove portions 131 (see Figs. 7 and 8) may be formed on the surface of the member which is joined by the first sintered copper layer 14. Specifically, the groove portions 131 may be formed on the surface of the first aluminum plate 12 on which the first intermediate metal layer 13 is formed and on the surface of the first metal member 15 on the first sintered copper layer 14 side (in the multilayer assembly 16, the surface of the first metal member 15 on which the second intermediate metal layer 17 is formed). The groove portions 131 will be described later.

### [Configuration of Multilayer Assembly 20]

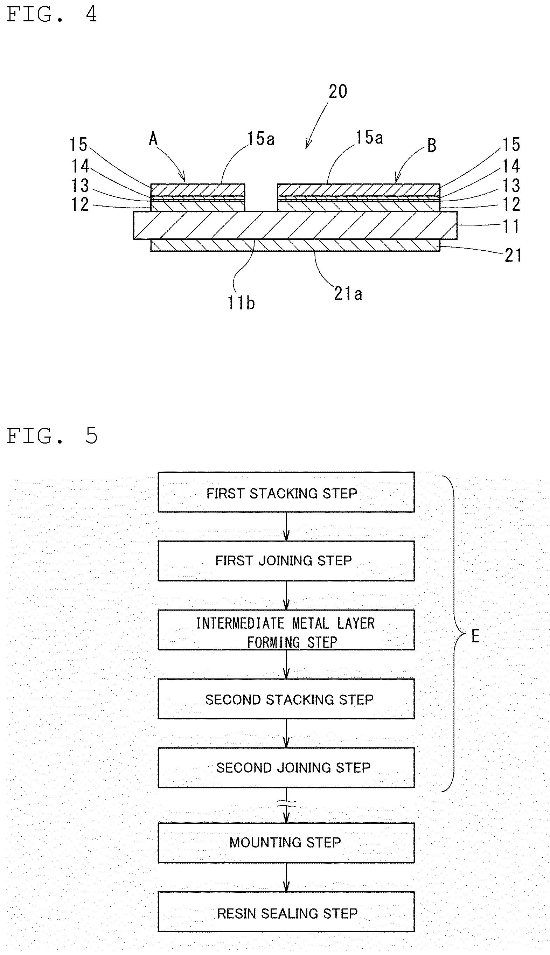

Furthermore, a multilayer assembly 20 made based on the multilayer assembly 10 shown in Fig. 1, in which a second aluminum plate 21 consisting of aluminum or an aluminum alloy is joined to the other surface 11b of the ceramic substrate 11, can also be provided as shown in Fig. 4. In a case where the multilayer assembly 20 is used as an insulating circuit board, the second aluminum plate 21 can be used as a heat sink.

The second aluminum plate 21 preferably has a plate thickness which is the same as or slightly different from that of the first aluminum plate 12, but may be thicker than the first aluminum plate 12 or formed to have a large area in order to increase the thermal capacity as a heat sink.

### [Method for Manufacturing Multilayer Assembly 20]

A method for manufacturing the multilayer assembly 20 shown in Fig. 4 will be described.

The steps in a range denoted by E in the flowchart shown in Fig. 5 are steps required for manufacturing the multilayer assembly 20. That is, the manufacturing method includes: a first stacking step of stacking, on the ceramic substrate 11, the first aluminum plate 12 and the second aluminum plate 21 through brazing materials 41 and 42, respectively, to form a first stacked body 50; a first joining step of achieving joining by pressing and heating the first stacked body 50 to form a first assembly 51; an intermediate metal layer forming step of forming the first intermediate metal layer 13 on a surface of the first aluminum plate 12 of the first assembly 51 opposite to the ceramic substrate 11; a second stacking step of stacking, on the first intermediate metal layer 13, the first joining material 310 and the first metal member 15 sequentially to form a second stacked body 52; and a second joining step of forming the first sintered copper layer 14 by sintering the first joining material 310 to join the first intermediate metal layer 13 and the first metal member 15. Hereinafter, the steps will be described in this order.

Fig. 5 shows the steps of up to the manufacturing of a semiconductor device by mounting an electronic component and the like on the manufactured multilayer assembly 20 and performing resin sealing after the steps denoted by E in which the multilayer assembly 20 is manufactured. The method for manufacturing a semiconductor device will be described later.

### (First Stacking Step)

As shown in Fig. 6, the first stacked body 50 is formed by stacking the first aluminum plate 12 on one surface 11a of the ceramic substrate 11 and stacking the second aluminum plate 21 on the other surface 11b through the brazing materials 41 and 42, respectively. As the brazing materials 41 and 42, an Al-Si-based, Al-Ge-based, Al-Cu-based, Al-Mg-based, Al-Mn-based, or Al-Si-Mg-based brazing material is used. The brazing materials 41 and 42 may be supplied as a foil or a paste.

As described above, in a case where the groove portions 131 are formed on the surface of the first aluminum plate 12 on the first sintered copper layer 14 side, as shown in Figs. 7 and 8 (cross-sectional views taken along the line G-G), the groove portions 131 are formed from one side to the other side of a rectangular surface 12a of the first aluminum plate 12, and the surface 12a of the first aluminum plate 12 is formed unevenly due to the groove portions 131 formed to be arranged in parallel. The groove portion 131 is formed to have, for example, a V-shape in cross section.

The groove portions 131 are formed to have the same dimensions. For example, the dimensions are set to satisfy a relationship of a > d > c ≥ b, where a [mm] is a pitch of the groove portions 131, b [mm] is a depth of the groove portions 131, c [mm] is a width of the groove portions 131, and d [mm] is a width of flat portions 132 provided between the groove portions 131. Therefore, in a case where the surface 12a of the first aluminum plate 12 is viewed in a plan view, an area s2 occupied by the flat portions 132 is set to be larger than an area s1 occupied by the groove portions 131 (s2 > s1).

The groove portion 131 is formed to have such a size that it remains as a groove portion even after the first intermediate metal layer 13 is formed on the surface of the first aluminum plate 12.

The same groove portions 131 may also be formed on the surface of the first metal member 15 on the first sintered copper layer 14 side.

### (First Joining Step)

The first stacked body 50 is heated while being pressed in the stacking direction, and is then cooled to form the first assembly 51 (see Fig. 9) in which the first aluminum plate 12 is joined to one surface 11a of the ceramic substrate 11 and the second aluminum plate 21 is joined to the other surface 11b.

In this case, the brazing materials 41 and 42 are melted by heating and diffuse in the first aluminum plate 12 and the second aluminum plate 21, thereby firmly joining the first aluminum plate 12 and the second aluminum plate 21 to the ceramic substrate 11. All the components of the brazing materials 41 and 42 may diffuse in the first aluminum plate 12 and the second aluminum plate 21, or remain as layers.

In this case, the joining conditions are not necessarily limited, but holding for 1 minute or longer and 60 minutes or shorter in a vacuum atmosphere with a pressing force of 0.1 MPa to 3.4 MPa in the stacking direction at a heating temperature of 610°C or higher and 655°C or lower is suitable.

### (Intermediate Metal Layer Forming Step)

As shown in Fig. 9, the first intermediate metal layer 13 is formed by plating or the like on the surface of the first aluminum plate 12 of the first assembly 51 opposite to the ceramic substrate 11. The first intermediate metal layer 13 may also be formed by a thin film forming technique other than plating. In addition, it may be formed by disposing a foil of any of copper, nickel, silver, or gold on the surface of the first aluminum plate 12 and performing diffusion joining.

### (Second Stacking Step)

The first joining material 310 is disposed on the first intermediate metal layer 13 as shown by the arrows in Fig. 9, and the first metal member 15 is placed on the first joining material 310 to form the second stacked body 52.

### (Second Joining Step)

The second stacked body 52 is heated while being pressed in the stacking direction to sinter the first joining material 310. In this case, holding for 3 minutes or longer and 60 minutes or shorter with a pressing force of 5 MPa or more and 10 MPa or less in the stacking direction at a heating temperature of 250°C or higher and 300°C or lower is suitable.

By the heating and pressing, the solvent 312 of the first joining material 310 and the coating 313 around the copper particles 311 are burned off, the plurality of copper particles 311 are sintered, and the first sintered copper layer 14 is formed. Then, the first intermediate metal layer 13 and the first metal member 15 are joined to the first sintered copper layer 14, and the multilayer assembly 20 shown in Fig. 4 is formed.

The multilayer assembly 20 manufactured as described above can be used as an insulating circuit board with a heat sink in which the surface 15a of the first metal member 15 is an electronic component mounting surface and the second aluminum plate 21 is a heat sink.

In this manufacturing method, first, the first aluminum plate 12 and the second aluminum plate 21 are joined to both surfaces of the ceramic substrate 11 by the first joining step, and then the first metal member 15 is joined on the first aluminum plate 12 through the first sintered copper layer 14 by the second joining step.

In this case, the first joining step is performed at a high temperature since the brazing material 41 is used for joining. However, since the same type of aluminum plates 12 and 21 are joined to both surfaces of the ceramic substrate 11, warpage after joining is less likely to occur. In particular, warpage is less likely to occur by using high-purity aluminum as the first aluminum plate 12 and the second aluminum plate 21, and is even less likely to occur by making the plate thicknesses the same or approximately the same.

In the next second joining step, since the members 13, 14, and 15 are joined only to one surface side (first aluminum plate 12 side) of the ceramic substrate 11, unbalance occurs in the stacked structure on both sides with the ceramic substrate 11 therebetween. However, since the heating temperature is suppressed and the joining is thus performed at a low temperature of 250°C or higher and 300°C or lower, the occurrence of warpage can be suppressed.

As described above, in the multilayer assembly (insulating circuit board with heat sink) 20, it is possible to perform good joining in which warpage is suppressed by using the first joining material 310, and thus it is possible to increase the area where the first metal member 15 and the first aluminum plate 12 are joined.

That is, in a case where these are joined using a copper paste, the organic component may cause the occurrence of voids due to heating during joining, and thus it is not possible to use a large amount of a copper paste. Thus, increasing the area where the first metal member 15 and the first aluminum plate 12 are joined may be restricted. On the other hand, in the present embodiment, the first joining material 310 formed into a sheet shape is used, and the amount of the organic component is reduced compared to a case of using a copper paste. Therefore, it is possible to suppress the occurrence of voids in the second joining step.

In this case, the planar size of the first aluminum plate 12 and the first metal member 15, that is, the size of the surface (joining surface) to be joined by the first joining material 310 is not particularly limited, but a first joining material 310 having a size of more than 100 mm² may be used for joining. In particular, in a case where a joining sheet formed into a sheet shape with a plurality of copper particles 311 bound by a binder, or a sintered copper sheet formed into a sheet shape with a part of copper particles 311 sintered is used as the first joining material 310, the surface of the first sintered copper layer 14 to be joined to the first metal member 15 can be made larger than in a case of using a copper paste.

Even in a case where the area is larger than 100 mm², voids caused by the volatilization of the binder can be reduced by joining using a sintered copper sheet as the first joining material 310. The size of the joining surface may be 200 mm² or more, or 500 mm² or more. In addition, the upper limit of the joining surface is not particularly limited, and may be 2,000 mm² or less, or 1,000 mm² or less.

The thickness of the first sintered copper layer 14 in the stacking direction is, for example, preferably 50 µm or more and 1,000 µm or less, and may be 500 µm or more. In particular, in a case where a sintered copper sheet formed into a sheet shape with a part of copper particles 311 sintered is used as the first joining material 310 for joining, the thickness of the first sintered copper layer 14 in the stacking direction can be made thicker than in a case of using a copper paste.

In the intermediate metal layer forming step, the first intermediate metal layer 13 containing any of copper, nickel, silver, or gold is formed on the surface of the first aluminum plate 12, and thus the first aluminum plate 12 and the first sintered copper layer 14 can be firmly joined through the first intermediate metal layer 13 in the second joining step.

Furthermore, due to the groove portions 131 formed on the surface of the first aluminum plate 12 and the surface of the first metal member 15 facing the first sintered copper layer 14, even in a case where a gas is generated from the organic component of the first joining material 310 due to heating during joining, the gas flows to the outside through the groove portions 131, and thus the occurrence of voids can be further suppressed. This can further improve joinability and further contribute to increasing the joining area.

### [Configuration of Semiconductor Device 100]

A semiconductor device 100 such as a power module shown in Fig. 10 can be manufactured by mounting an electronic component 70 such as a power device on the surface 15a of the first metal member 15 of the multilayer assembly 20 shown in Fig. 4. In the semiconductor device 100 shown in Fig. 10, electronic components 70 are joined to the surface 15a of the first metal member 15, tip portions of lead frames 71 consisting of a copper alloy are joined to the electronic components 70, and sealing is performed using an insulating resin 72.

In this case, the entire configuration is embedded in the insulating resin 72 in a state in which a surface 21a of the second aluminum plate 21 opposite to the ceramic substrate 11 and end portions of the lead frames 71 are exposed. In the example shown in the drawing, a plurality of the electronic components 70 are mounted, each lead frame 71 is connected to the electronic component 70 and a part of the first metal member 15, and an end portion of each lead frame 71 is exposed in a state of protruding from the insulating resin 72. The reference sign 73 denotes a solder material.

### [Method for Manufacturing Semiconductor Device 100]

A method for manufacturing the semiconductor device 100 will be described. The method includes, as described after the manufacturing process of the multilayer assembly 20 denoted by E in Fig. 5, a mounting step of mounting the electronic component 70 and the like after the second joining step and a resin sealing step of sealing the electronic component 70 and the like with the insulating resin 72 after the mounting step. Hereinafter, these steps will be described.

### (Mounting Step)

A coating is formed on the surface of the first metal member 15 in the multilayer assembly 20 by nickel plating or the like, and the electronic component 70 is joined thereon using the solder material 73. As the solder material 73, an Sn-Ag-Cu-based, Zn-Al-based, Sn-Ag-based, Sn-Cu-based, Sn-Sb-based, or Pb-Sn-based solder material is used. In addition, one end portion of the lead frame 71 is connected to the electronic component 70 using the solder material 73. The lead frame 71 consists of copper or a copper alloy, and is formed into a plate shape or the like having a narrow width.

In a case where a plurality of the electronic components 70 are connected to each other, the electronic components 70 may be connected by wire bonding, for example. In addition, in a case where the lead frames 71 are connected to the electronic components 70, they may be connected using the solder material 73 or by wire bonding, for example. In this case, bonding wires are embedded in the insulating resin 72 by the next resin sealing step.

### (Resin Sealing Step)

The entire configuration including the electronic components 70 is sealed with the insulating resin 72 in a state in which the surface 21a of the second aluminum plate 21 opposite to the ceramic substrate 11 in the multilayer assembly 20 and the end portion of each lead frame 71 opposite to the electronic component 70 are exposed.

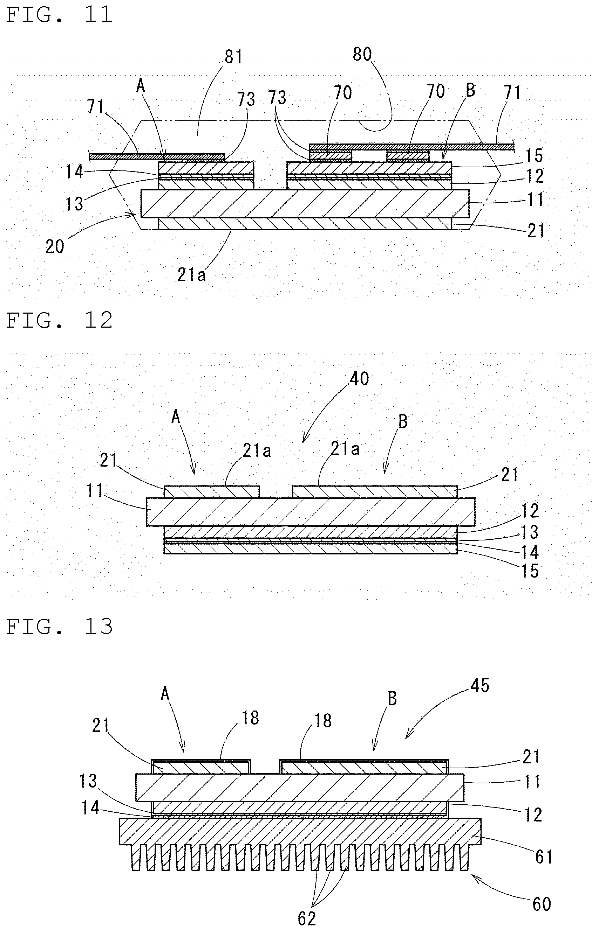

Specifically, as shown in Fig. 11, using a mold 80 for injection molding, the multilayer assembly 20 is disposed in a cavity 81 of the mold 80 in a state in which the surface 21a of the second aluminum plate 21 is in contact with an inner surface of the mold 80. In addition, the end portion of each lead frame 71 opposite to the electronic component 70 is held to be disposed in a gap of the mold or the like and not to be exposed to the cavity 81.

As shown in Fig. 11, the multilayer assembly 20 is fixed so as not to move in the cavity 81 in a state of being disposed in the mold 80 for injection molding, and the insulating resin 72 such as an epoxy resin is injected into the cavity 81. In a case where the mold 80 is opened after solidification of the insulating resin 72, the semiconductor device 100 in a state of being sealed with the insulating resin 72 can be taken out.

The semiconductor device 100 (see Fig. 10) manufactured as described above is used in such a form that the surface 21a of the second aluminum plate 21 exposed from the insulating resin 72 is applied with a conductive grease or the like and fixed to a cooler or the like, making contact with it.

In the multilayer assembly 20 shown in Fig. 4, the second intermediate metal layer 17 may be formed between the first metal member 15 and the first sintered copper layer 14 as shown in Fig. 3 in the intermediate metal layer forming step. Specifically, in the intermediate metal layer forming step shown in Fig. 5, the first intermediate metal layer 13 is formed on the first aluminum plate 12, and the second intermediate metal layer 17 is formed on the surface of the first metal member 15. In the second stacking step, the first metal member 15 is placed so that the second intermediate metal layer 17 on the surface of the first metal member 15 is in contact with the first joining material 310 (see Fig. 9), and is then joined in the second joining step. This is effective in a case where the first metal member 15 contains aluminum or an aluminum alloy.

Regarding the semiconductor device 100 shown in Fig. 10, an example is shown in which the surface 15a of the first metal member 15 in the multilayer assembly 20 shown in Fig. 4 is an electronic component mounting surface. However, the surface 21a of the second aluminum plate 21 opposite to the ceramic substrate 11 can also be an electronic component mounting surface.

### [Configuration of Multilayer Assembly 40]

Fig. 12 shows a multilayer assembly 40 in which the surface 21a of the second aluminum plate 21 opposite to the ceramic substrate 11 is an electronic component mounting surface, contrary to Fig. 4. The reference signs of the components are the same as those in Fig. 4 (the same also applies to Figs. 13 and subsequent drawings), but in order to facilitate comparison with Fig. 4, the first aluminum plate 12 and the like on one side of the ceramic substrate 11 are shown as one stacked part, and the second aluminum plate 21 is shown as two parts A and B separated from each other. The multilayer assembly 40 has the same stacked structure as the multilayer assembly 20 shown in Fig. 4.

### [Configuration of Multilayer Assembly 45]

Fig. 13 shows a multilayer assembly 45 as an application example of the multilayer assembly 40 shown in Fig. 12. In the multilayer assembly 45, the first aluminum plate 12 is joined to one surface of the ceramic substrate 11, the second aluminum plate 21 is joined to the other surface, the first intermediate metal layer 13 is formed on the surface of the first aluminum plate 12, a third intermediate metal layer 18 is formed on the surface of the second aluminum plate 21, and a first metal member 60 is joined to the first intermediate metal layer 13 on the first aluminum plate 12 through the first sintered copper layer 14. In an insulating circuit board, the second aluminum plate 21 corresponds to a circuit layer, and the first metal member 60 corresponds to a heat sink.

In the example shown in Fig. 13, the first intermediate metal layer 13 is formed by plating containing any of copper, nickel, silver, or gold. In order to increase the adhesion to an electronic component as a circuit layer, the third intermediate metal layer 18 is also formed on the surface of the second aluminum plate 21 by plating containing any of copper, nickel, silver, or gold.

The first aluminum plate 12 is shown as one stacked part, but the second aluminum plate 21 constituting the circuit layer is shown as two parts A and B separated from each other as in Fig. 1 and the like. In addition, the first metal member 60 contains any of aluminum, an aluminum alloy, copper, or a copper alloy, and is formed into a shape of a heat sink with fins in which a large number of fins 62 having a pin shape or a plate shape are erected in parallel with each other on one surface of a metal plate portion 61 having a flat plate shape.

### [Configuration of Semiconductor Device 110]

Next, a semiconductor device 110 using the multilayer assembly 45 will be described.

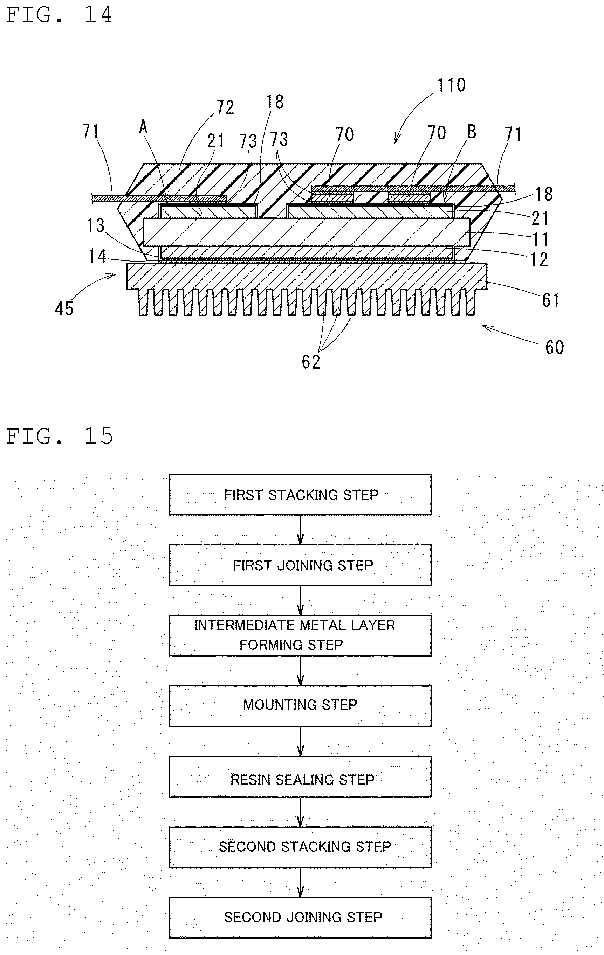

As shown in Fig. 14, in the semiconductor device 110, the electronic component 70 is joined through the solder material 73 on the third intermediate metal layer 18 formed on the second aluminum plate 21 denoted by the reference sign B in the multilayer assembly 45, the lead frame 71 is joined to the electronic component 70 and the third intermediate metal layer 18 on the second aluminum plate 21 denoted by the reference sign A through the solder material 73, and the electronic component 70 is sealed with the insulating resin 72 in a state in which the first metal member (heat sink) 60 and an end portion of each lead frame 71 are exposed. Specifically, from the interface between the first intermediate metal layer 13 on the surface of the first aluminum plate 12 and the first sintered copper layer 14, the entire first metal member 60 is exposed from the insulating resin 72.

### [Method for Manufacturing Semiconductor Device 110]

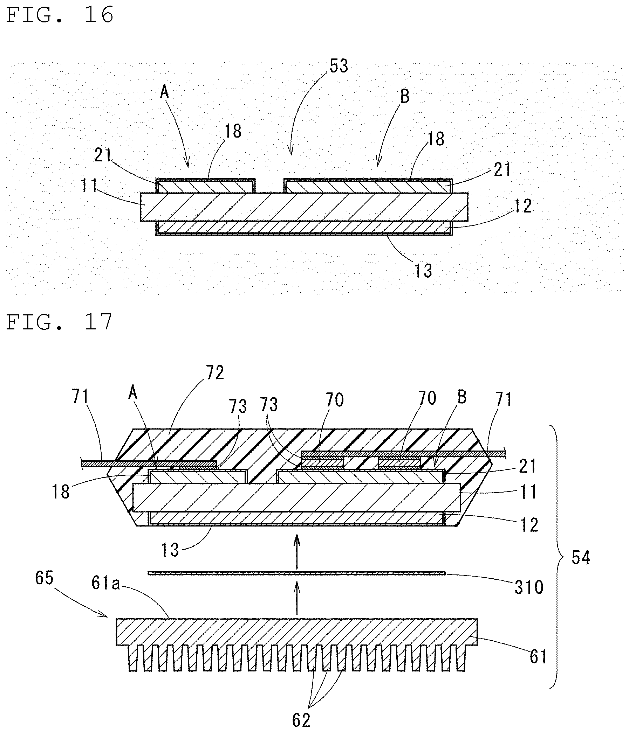

A method for manufacturing the semiconductor device 110 will be described with reference to the flowchart shown in Fig. 15. First, the first aluminum plate 12 and the second aluminum plate 21 are stacked on both surfaces of the ceramic substrate 11 through the brazing materials 41 and 42 (see Fig. 6), respectively, to form a first stacked body (first stacking step), and the first stacked body is pressed and heated for joining to form a first assembly 53 as shown in Fig. 16 (first joining step).

The steps described so far are the same as those for the multilayer assembly 20 shown in Fig. 4. It is noted that a plurality of groove portions 131 may be formed on the surface of the first aluminum plate 12 opposite to the ceramic substrate.

Next, the first intermediate metal layer 13 containing any of copper, nickel, silver, or gold is formed on the surface of the first aluminum plate 12 of the first assembly 53 by plating or the like (intermediate metal layer forming step). As described above, in the example shown in Fig. 16, in order to improve the joinability with an electronic component, a coating of the third intermediate metal layer 18 containing any of copper, nickel, silver, or gold is also formed on the surface of the second aluminum plate 21. In a case where the first intermediate metal layer 13 or the third intermediate metal layer 18 is made of silver or gold, a nickel coating may be formed as an underlayer, and the first intermediate metal layer 13 or the third intermediate metal layer 18 may be formed thereon.

After the intermediate metal layer forming step, the electronic components 70 are joined on the second aluminum plate 21 using the solder material 73, and one end portion of the lead frame 71 is connected to the electronic component 70 (mounting step).

Next, as shown in Fig. 17, the entire configuration including the electronic components 70 is sealed with the insulating resin 72 in a state in which the first intermediate metal layer 13 on the surface of the first aluminum plate 12 opposite to the ceramic substrate 11 and an end portion of each lead frame 71 opposite to the electronic component 70 are exposed (resin sealing step).

Next, on the first intermediate metal layer 13 exposed from the insulating resin 72, the first joining material 310 and the first metal member 60 are sequentially stacked as shown by the arrows in Fig. 17 to form a second stacked body 54 (second stacking step). In this case, since the first metal member 60 is formed as a heat sink with fins having a plurality of fins 62 on one surface of the metal plate portion 61, a surface 61a of the metal plate portion 61 opposite to the fins 62 is brought into contact with the first joining material 310.

As described above, the first joining material 310 includes a plurality of copper particles 311 of 90% by mass or more and 99% by mass or less and a solvent (binder) 312 of 1% by mass or more and 10% by mass or less, and the copper particles 311 are covered with a coating 313 of an organic substance.

An intermediate metal layer (second intermediate metal layer) containing any of copper, nickel, silver, or gold may be formed on the surface (in Fig. 17, the surface of the metal plate portion 61 opposite to the fins 62) 61a which is in contact with the first joining material 310 in the first metal member 60. In particular, in a case where the first metal member 60 is made of aluminum or an aluminum alloy, the formation of the intermediate metal layer makes it possible to achieve good joining in the next second joining step.

Furthermore, a plurality of groove portions (groove portions 131 shown in Figs. 7 and 8) may be formed on the surface 61a which is in contact with the first joining material 310 in the first metal member 60.

Then, the second stacked body 54 is pressed in the stacking direction and heated to sinter the copper particles 311 of the first joining material 310, and thus the first metal member 60 and the first intermediate metal layer 13 are joined through the first sintered copper layer 14 (second joining step), thereby forming the semiconductor device 110 shown in Fig. 14. In this case, holding for 3 minutes or longer and 60 minutes or shorter with a pressing force of 5 MPa or more and 10 MPa or less at a heating temperature of 250°C or higher and 300°C or lower is suitable.

In this manufacturing method, the second joining step accompanied by pressing and heating is performed after the mounting step and the resin sealing step. However, in the second joining step, the first sintered copper layer 14 is provided for joining, the heating temperature is suppressed, and the joining is performed at a low temperature of 250°C or higher and 300°C or lower, so that it is possible to suppress the thermal influences on the electronic components 70, the insulating resin 72, and the like.

### [Configuration of Multilayer Assembly 30]

It is also possible to further join a second metal member to the second aluminum plate 21 of the multilayer assembly 20 shown in Fig. 4 through a sintered copper layer.

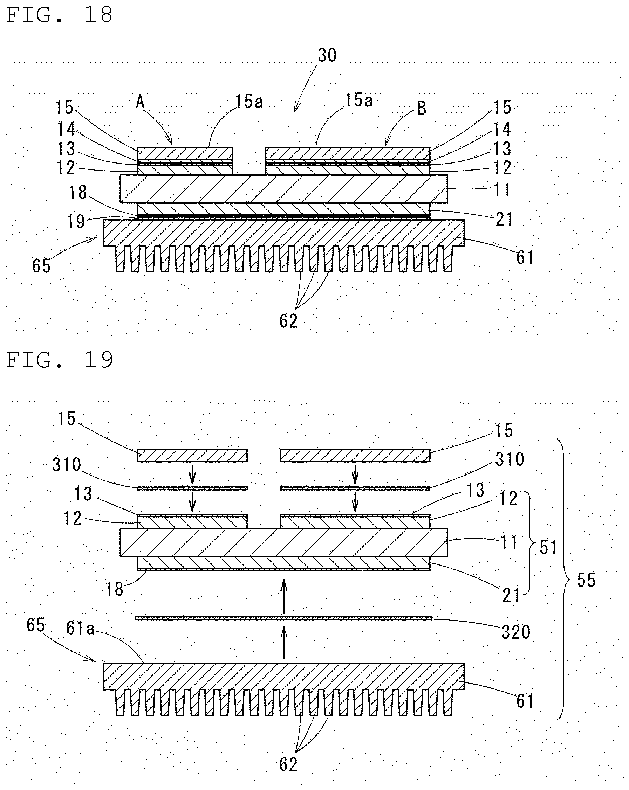

Fig. 18 shows such a multilayer assembly 30, in which a second metal member 65 is joined to the second aluminum plate 21 through the third intermediate metal layer 18 and a second sintered copper layer 19. The third intermediate metal layer 18 contains any of copper, nickel, silver, or gold. The second sintered copper layer 19 is formed by sintering the copper particles 311 in the same manner as the first sintered copper layer 14.

In the multilayer assembly 30 shown in Fig. 18, similar to the first metal member 60 of Fig. 13 and the like, the second metal member 65 contains any of aluminum, an aluminum alloy, copper, or a copper alloy, and is formed into a shape of a heat sink with fins in which one surface of a metal plate portion 61 having a flat plate shape has a plurality of fins 62.

That is, in the multilayer assembly 20 shown in Fig. 4, the second aluminum plate 21 can be used as a heat sink, but in the multilayer assembly 30 shown in Fig. 18, the second aluminum plate 21 is provided as a metal plate for heat transfer and the second metal member 65 as a heat sink is further joined to the second aluminum plate 21.

### [Method for Manufacturing Multilayer Assembly 30]

In the manufacturing of the multilayer assembly 30, as shown in the range denoted by the reference sign E in Fig. 5, the first aluminum plate 12 and the second aluminum plate 21 are joined to the ceramic substrate 11 by brazing through the first stacking step and the first joining step, and the first assembly 51 is formed.

Next, the first intermediate metal layer 13 and the third intermediate metal layer 18 are formed on the surfaces of the first aluminum plate 12 and the second aluminum plate 21 opposite to the ceramic substrate 11, respectively, by the intermediate metal layer forming step. Next, as shown in Fig. 19, the first metal member 15 is disposed on the first intermediate metal layer 13 through the first joining material 310, and the second metal member 65 is disposed on the third intermediate metal layer 18 through the second joining material 320 (second stacking step) to form a second stacked body 55.

Similar to the first joining material 310, the second joining material 320 includes a plurality of copper particles 311 of 90% by mass or more and 99% by mass or less and a solvent 312 of 1% by mass or more and 10% by mass or less (see Fig. 2).

Then, by holding the second stacked body 55 at a heating temperature of 250°C or higher and 300°C or lower for 3 minutes or longer and 60 minutes or shorter in a state of pressing it in the stacking direction at a pressure of 5 MPa or more and 10 MPa or less, the copper particles 311 of the first joining material 310 and the second joining material 320 are sintered. Thus, the first sintered copper layer 14 and the second sintered copper layer 19 are formed, and the first intermediate metal layer 13 and the first metal member 15 on the surface of the first aluminum plate 12 and the third intermediate metal layer 18 and the second metal member 65 on the surface of the second aluminum plate 21 are respectively joined (second joining step).

The multilayer assembly 30 manufactured as described above can be used as an insulating circuit board with a heat sink in which the surface 15a of the first metal member 15 is an electronic component mounting surface and the second metal member 65 is a heat sink.

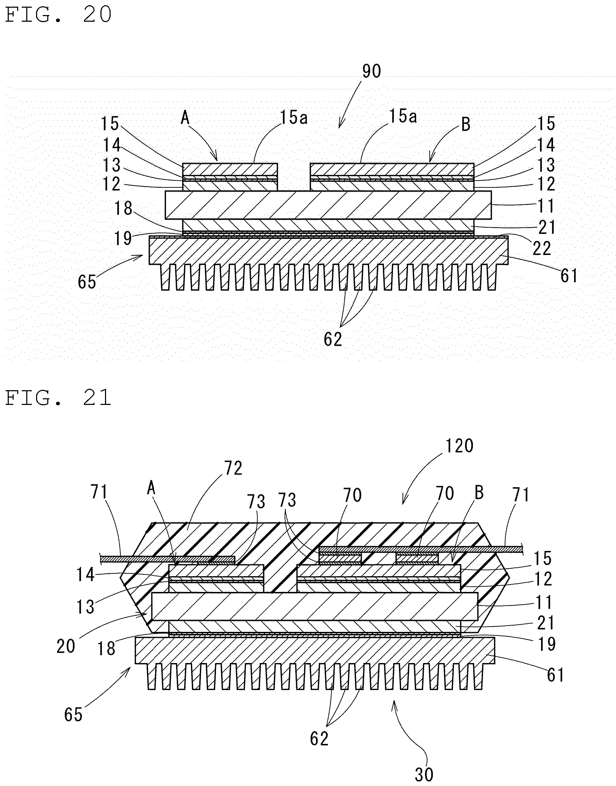

In a case where the second metal member 65 is made of a material containing aluminum or an aluminum alloy in the multilayer assembly 30, a fourth intermediate metal layer 22 may be formed on one surface of the second metal member 65, that is, on the surface of the metal plate portion 61 (between the second metal member 65 and the second sintered copper layer 19) as shown in a multilayer assembly 90 of Fig. 20.

The fourth intermediate metal layer 22 contains any of copper, nickel, silver, or gold, and can increase the joinability between the second metal member 65 and the second sintered copper layer 19. Groove portions 131 may be formed on the surface of the metal plate portion 61 of the second metal member 65 to be joined to the second sintered copper layer 19.

### [Configuration of Semiconductor Device 120]

The multilayer assembly 30 can also be provided as a semiconductor device 120 shown in Fig. 21. In the semiconductor device 120, compared to the semiconductor device 100 shown in Fig. 10, the third intermediate metal layer 18 containing any of copper, nickel, silver, or gold is formed on the surface 21a of the second aluminum plate 21, which is exposed from the insulating resin 72, and the second metal member 65 containing any of aluminum, an aluminum alloy, copper, or a copper alloy and having a shape of a heat sink with fins is joined to the third intermediate metal layer 18 through the second sintered copper layer 19.

### [Method for Manufacturing Semiconductor Device 120]

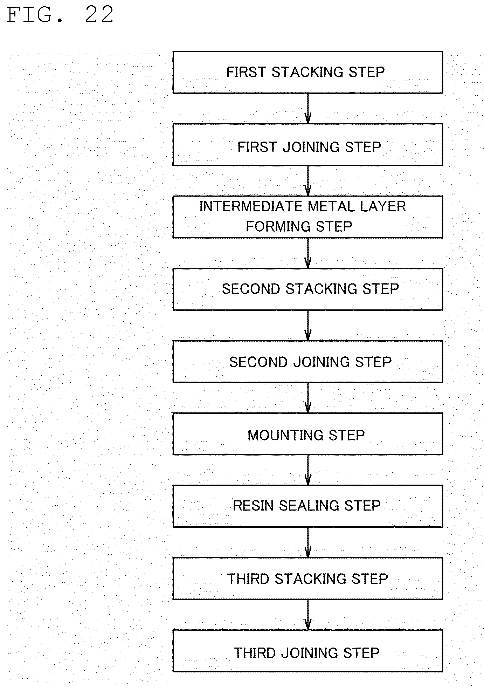

In the manufacturing the semiconductor device 120, as shown in Fig. 22, the first aluminum plate 12 and the second aluminum plate 21 are stacked on the ceramic substrate 11 through the brazing materials 41 and 42 (first stacking step), respectively, and pressing and heating are performed to form the first assembly (first joining step). In the first assembly, the first intermediate metal layer 13 and the third intermediate metal layer 18 are formed on at least the surfaces of the first aluminum plate 12 and the second aluminum plate 21 opposite to the ceramic substrate 11 (intermediate metal layer forming step), respectively, and the first metal member 15 is stacked on the first intermediate metal layer 13 through the first joining material 310 (second stacking step).

Next, the first joining material 310 is sintered by pressing and heating, so that the first intermediate metal layer 13 and the first metal member 15 are joined by the first sintered copper layer 14 (second joining step).

Thereafter, the electronic components 70 and the lead frames 71 are joined to the surface of the first metal member 15 by the solder material 73 (mounting step), and the electronic components 70 and the like are sealed with the insulating resin 72 in a state in which the surface of the third intermediate metal layer 18 and end portions of the lead frames 71 are exposed (resin sealing step).

Through the steps so far, a structure similar to the semiconductor device 100 shown in Fig. 10 is manufactured. A point different from the semiconductor device 100 is that the third intermediate metal layer 18 is formed on the surface 21a of the second aluminum plate 21 exposed from the insulating resin 72.

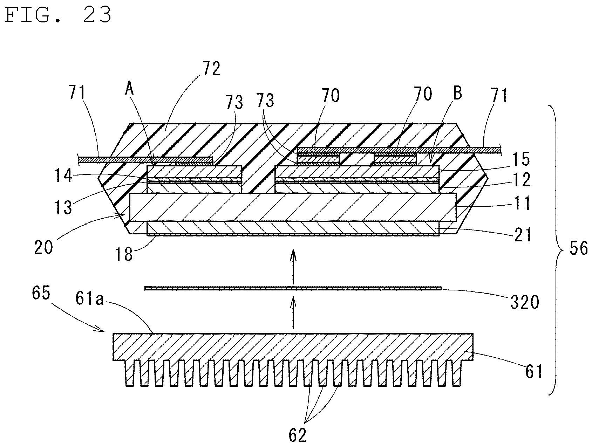

Next, the second joining material 320 and the second metal member 65 are sequentially stacked on the third intermediate metal layer 18 as shown by the arrows in Fig. 23, and a third stacked body 56 is formed (third stacking step) .

Finally, the third stacked body 56 is pressed and heated to sinter the copper particles of the second joining material 320, and thus the second sintered copper layer 19 is formed. The third intermediate metal layer 18 on the surface of the second aluminum plate 21 and the second metal member 65 are joined by the second sintered copper layer 19 (third joining step). By the third joining step, the semiconductor device 120 shown in Fig. 21 is manufactured.

In the method for manufacturing the semiconductor device 120, the third joining step accompanied by pressing and heating is also performed after the mounting step and the resin sealing step. However, in the third joining step, the second sintered copper layer 19 is provided for joining, the heating temperature is suppressed, and the joining is performed at a low temperature of 250°C or higher and 300°C or lower, so that it is possible to suppress the thermal influences on the electronic components 70, the insulating resin 72, and the like.

The present invention is not limited to the above-described embodiments.

The first aluminum plate 12 and the second aluminum plate 21 joined to the ceramic substrate 11 are made of a material containing aluminum or an aluminum alloy, and preferably consist of aluminum or an aluminum alloy. However, the first metal members 15 and 60 and the second metal member 65 may be made of a material containing any of aluminum, an aluminum alloy, copper, or a copper alloy.

On the surfaces of the first aluminum plate 12 and the second aluminum plate 21, the intermediate metal layers 13 and 18 containing any of copper, nickel, silver, or gold are formed, respectively, to improve the joinability with the sintered copper layers 14 and 19. In a case where the first metal members 15 and 60 and the second metal member 65 are also made of a material containing aluminum or an aluminum alloy, an intermediate metal layer (second intermediate metal layer 17) containing any of copper, nickel, silver, or gold may be formed on the joining surfaces with the sintered copper layers 14 and 19.

In a case where the first metal members 15 and 60 and the second metal member 65 are made of a material containing copper or a copper alloy, an intermediate metal layer containing any of copper, nickel, silver, or gold may also be formed on the joining surface with the sintered copper layer.

Furthermore, groove portions 131 may be formed on the surfaces of the first aluminum plate 12 and the second aluminum plate 21 to be joined to the sintered copper layer and the surfaces of the first metal members 15 and 60 and the second metal member 65. In this case, even in a case where a gas is generated from the organic components of the joining materials 310 and 320 due to heating during joining, the gas flows to the outside through the groove portions 131, and thus the occurrence of voids can be further suppressed.

### Examples

Experiments were conducted to confirm the effects of the present invention.

### (1) Manufacturing of First Assembly

First, aluminum plates were stacked on both surfaces of a ceramic substrate through a brazing material, respectively. The resulting stacked body was heated while pressed in a stacking direction to form a first aluminum plate 12 on one surface of the ceramic substrate 11 and form a second aluminum plate 21 on the other surface, and thus a first assembly was manufactured.

### (1-1) Materials of First Assembly

Ceramic substrate: Si₃N₄ (thickness: 0.32 mm)
First aluminum plate and second aluminum plate: 4N aluminum (thickness: 0.6 mm, length: 30 mm, width: 40 mm)
Brazing material: brazing material foil (thickness: 0.02 mm) consisting of Al-7.5 mass% Si alloy

### (1-2) Manufacturing Conditions of First Assembly

Pressing force for joining: 0.2 MPa
Heating temperature: 650°C
Holding time: 30 minutes
Joining atmosphere: vacuum

### (2) Manufacturing of Second Assembly

Next, a first intermediate metal layer 13 consisting of a plating coating of any of copper, nickel, silver, or gold (Examples 1 to 9) was formed on a surface of the first aluminum plate 12 opposite to the ceramic substrate 11 by plating, and in a state in which a first metal member 15 was stacked on the first intermediate metal layer 13 through a first joining material 310, heating was performed to form a first sintered copper layer 14. Therefore, the first metal member 15 was joined and a second assembly (sample) was thus manufactured.

Second assemblies (samples) were manufactured in the same manner as in Examples 1 to 9, except that in Comparative Example 1, the first intermediate metal layer 13 was not formed, and in Comparative Example 2, a chromium plating (Cr plating) coating was formed as the first intermediate metal layer 13.

For the first metal member 15, an aluminum plate or a copper plate is used and formed into a rectangular shape. It has a length of 30 mm and a width of 40 mm. The first intermediate metal layers (plating films) in Examples are as shown in Table 1. In a case where the first intermediate metal layer 13 was made of chromium, gold, or silver, a nickel plating coating was formed as an underlayer on the surface of the first aluminum plate 12.

### (2-1) Groove Portions

In Example 8, in the second assembly as a sample, groove portions 131 are formed on the surface of the first aluminum plate 12 where the first intermediate metal layer 13 is formed. Regarding the groove portions 131, a pitch (interval between deepest portions) a of the groove portions 131 shown in Fig. 7 is 1.5 [mm], a depth b of the groove portions 131 is 0.3 [mm], a width c of the groove portions 131 is 0.5 [mm], and a width d of a flat portion 132 provided between the groove portions 131 is 1.0 [mm]. 20 groove portions 131 extending from one edge to the other edge are formed on the surface which is joined to the first sintered copper layer 14.

### (2-2) Joining Surface of First Metal Member 15 with First Sintered Copper Layer 14

The first metal member 15 was made of an aluminum alloy (JIS6063 series) or a copper alloy (JIS1020 series), and samples (Examples 2 to 4 and Comparative Example 2) in which, on the surface to be joined to the first sintered copper layer 14, a nickel plating coating was provided as a second intermediate metal layer 17 by a surface treatment, and samples (Examples 1 and 5 to 9 and Comparative Example 1) in which no plating coating (second intermediate metal layer) was provided were prepared. The materials of the first metal member 15 and the second intermediate metal layer of each Example are as shown in Table 1.

### (2-3) First Joining Material

The first joining material is a sintered Cu material formed of copper particles, and joins the first intermediate metal layer 13 and the first metal member 15 (or the second intermediate metal layer 17 on the surface of the first metal member 15) by sintering the copper particles through heating. In Examples 1 to 7 and 9, a joining material formed into a sheet shape with copper particles 311 bound by a solvent 312 was used, and in Examples 8 and Comparative Examples 1 and 2, a paste-like joining material was used.

### (2-4) Manufacturing Conditions of Second Assembly

Pressing force: 5 MPa
Heating temperature: 300°C
Holding time: 15 minutes
Joining atmosphere: vacuum
Sheet-like joining material: It has a thickness of 300 um, and its dimensions in length and width are the same as those of the aluminum plate.

### (2-5) Resin Sealing

In Example 9, before the second joining step, the sealing with an insulating resin was performed in a state in which the surface of the second aluminum plate of the first assembly opposite to the ceramic substrate was exposed.

### (3) Evaluation of Joining Ratio

### (3-1) Evaluation Method

The joining interface between the first aluminum and the first metal member in the second assembly was observed by ultrasonic flaw detection equipment, and an ultrasonic image of the joining interface was subjected to image processing and evaluated.

As an evaluation method, a joining ratio was calculated from Expression (1). Joining Ratio (%) = [{ (Joining Area) - (Peeling Area)}/(Joining Area)] × 100

In the ultrasonic flaw detection image (binarized image), a place where the joining was made was shown in black, and a place where the peeling was made (a place where the joining was not made) was shown in white. Therefore, the total area of the white places was defined as a peeling area.

Cases where the joining ratio was 90% or more were evaluated as acceptable. Among them, cases where the joining ratio was 97% or more were evaluated as "A", and cases where the joining ratio was 90% or more and less than 97% were evaluated as "B". Cases where the joining ratio was 0% or more and less than 90% were evaluated as unacceptable (NG) and denoted by "C".

These results are shown in Table 1.

In Table 1, regarding the first intermediate metal layer, the copper plating coating is indicated by "Cu plating film", the nickel plating coating is indicated by "Ni plating film", the gold plating coating is indicated by "Au plating film", the silver plating coating is indicated by "Ag plating film", the chromium plating coating is indicated by "Cr plating", and a case where no first intermediate metal layer is formed is indicated by "no plating". Regarding the form of the joining material, a sheet-like joining material is indicated by "sheet", and a paste-like joining material is indicated by "paste".

**[Table 1]**

| | Groove Processing for First Aluminum Plate | First Intermediate Metal Layer | First Metal Member | Second Intermediate Metal Layer | First Joining Material | Insulating Resin | Evaluation of Joining |
|---|---|---|---|---|---|---|---|
| Example 1 | Absence | Cu Plating Film | Copper | Absence | Sheet | Absence | A |
| Example 2 | Absence | Cu Plating Film | Copper | Ni Plating Film | Sheet | Absence | A |
| Example 3 | Absence | Cu Plating Film | Aluminum | Ni Plating Film | Sheet | Absence | A |
| Example 4 | Absence | Ni Plating Film | Aluminum | Ni Plating Film | Sheet | Absence | A |
| Example 5 | Absence | Ni Plating Film | Copper | Absence | Sheet | Absence | A |
| Example 6 | Absence | Ag Plating Film | Copper | Absence | Sheet | Absence | A |
| Example 7 | Absence | Au Plating Film | Copper | Absence | Sheet | Absence | A |
| Example 8 | Presence | Cu Plating Film | Copper | Absence | Paste | Absence | B |
| Example 9 | Absence | Cu Plating Film | Copper | Absence | Sheet | Presence | A |
| Comparative Example 1 | Absence | No Plating | Copper | Absence | Paste | Absence | c |
| Comparative Example 2 | Absence | Cr Plating Film | Aluminum | Ni Plating Film | Paste | Absence | c |

### (3-2) Evaluation

As shown in Table 1, it was possible to confirm that, in the second assemblies of Examples 1 to 9, the joining state was good, there was little or no non-joining portion at the joining interface, and the peeling rarely occurred.

In Examples 1 to 7 and 9, the copper particles 311 of the sheet-like joining material are sintered and constitute a sintered copper layer. In this sintered copper layer, the occurrence of voids is suppressed between the first aluminum plate and the first metal member, and the first aluminum plate and the first metal member are joined in a good joining state. In addition, in Example 8, although the copper paste was used, the entire joining state was good due to the groove portions formed in the first aluminum plate.

For Example 9 in which the second joining step was performed after sealing with the insulating resin, the appearance was visually inspected, and as a result, thermal influences (discoloration, deformation, and the like) on the insulating resin were not confirmed.

On the other hand, in the second assemblies of Comparative Examples 1 and 2, the joining ratio was less than 90%, and the non-joining and the peeling were confirmed at the interface.

### Industrial Applicability

In a case where a heat sink is joined to an insulating circuit board, for example, a first metal member can be joined at a low temperature by a sintered copper layer, and thus it is possible to suppress warpage and improve joinability.

### Reference Signs List

10, 16, 20, 30, 40, 45, 90: MULTILAYER ASSEMBLY
11: CERAMIC SUBSTRATE
12: FIRST ALUMINUM PLATE
13: FIRST INTERMEDIATE METAL LAYER
14: FIRST SINTERED COPPER LAYER
15, 60: FIRST METAL MEMBER
17: SECOND INTERMEDIATE METAL LAYER
18: THIRD INTERMEDIATE METAL LAYER
21: SECOND ALUMINUM PLATE
41, 42: BRAZING MATERIAL
50: FIRST STACKED BODY
51, 53: FIRST ASSEMBLY
52, 54, 55: SECOND STACKED BODY
56: THIRD STACKED BODY
65: SECOND METAL MEMBER
70: ELECTRONIC COMPONENT
71: LEAD FRAME
72: INSULATING RESIN
73: SOLDER MATERIAL
80: MOLD FOR INJECTION MOLDING
81: CAVITY
100, 110, 120: SEMICONDUCTOR DEVICE
131: GROOVE PORTION
132: FLAT PORTION
310: FIRST JOINING MATERIAL
320: SECOND JOINING MATERIAL

## Claims

1. A multilayer assembly comprising:
a ceramic substrate;
a first aluminum plate which is joined to one surface of the ceramic substrate and contains aluminum or an aluminum alloy;
a first intermediate metal layer which is joined to a surface of the first aluminum plate opposite to the ceramic substrate and contains any of copper, nickel, silver, or gold;
a first sintered copper layer which is joined to a surface of the first intermediate metal layer opposite to the first aluminum plate; and
a first metal member which is joined to a surface of the first sintered copper layer opposite to the first intermediate metal layer and contains any of aluminum, an aluminum alloy, copper, or a copper alloy.

2. The multilayer assembly according to claim 1,
wherein the first metal member contains aluminum or an aluminum alloy, and
a second intermediate metal layer containing any of copper, nickel, silver, or gold is formed between the first metal member and the first sintered copper layer.

3. The multilayer assembly according to claim 1 or 2,
wherein a second aluminum plate consisting of aluminum or an aluminum alloy is joined to the other surface of the ceramic substrate.

4. The multilayer assembly according to claim 3, further comprising:
a third intermediate metal layer which is joined to a surface of the second aluminum plate opposite to the ceramic substrate and contains any of copper, nickel, silver, or gold;
a second sintered copper layer which is joined to a surface of the third intermediate metal layer opposite to the second aluminum plate; and
a second metal member which is joined to a surface of the second sintered copper layer opposite to the second aluminum plate and contains any of aluminum, an aluminum alloy, copper, or a copper alloy.

5. The multilayer assembly according to claim 4,
wherein the second metal member contains aluminum or an aluminum alloy, and
a fourth intermediate metal layer containing any of copper, nickel, silver, or gold is formed between the second metal member and the second sintered copper layer.

6. A semiconductor device using the multilayer assembly according to claim 3, the device comprising:
an electronic component which is mounted on a surface of the first metal member opposite to the first sintered copper layer;
a lead frame which is connected to the electronic component; and
an insulating resin which seals the electronic component in a state in which a tip portion of the lead frame and at least a surface of the second aluminum plate opposite to the ceramic substrate are exposed.

7. A semiconductor device using the multilayer assembly according to claim 3, the device comprising:
an electronic component which is mounted on a surface of the second aluminum plate opposite to the ceramic substrate;
a lead frame which is connected to the electronic component; and
an insulating resin which seals the electronic component in a state in which a tip portion of the lead frame and at least a surface of the first metal member excluding a joining surface with the first sintered copper layer are exposed.

8. A semiconductor device using the multilayer assembly according to claim 4, the device comprising:
an electronic component which is mounted on a surface of the first metal member opposite to the first sintered copper layer;
a lead frame which is connected to the electronic component; and
an insulating resin which seals the electronic component in a state in which a tip portion of the lead frame and at least a surface of the second metal member excluding a joining surface with the second sintered copper layer are exposed.

9. A method for manufacturing a multilayer assembly, the method comprising:
a first stacking step of stacking, on one surface of a ceramic substrate, a brazing material and a first aluminum plate containing aluminum or an aluminum alloy to form a first stacked body;
a first joining step of achieving joining by pressing and heating the first stacked body in a stacked state to form a first assembly;
an intermediate metal layer forming step of forming a first intermediate metal layer containing any of copper, nickel, silver, or gold on a surface of the first aluminum plate of the first assembly opposite to the ceramic substrate;
a second stacking step of sequentially stacking, on the first intermediate metal layer, a first joining material formed into a sheet shape with a plurality of copper particles bound by a binder and a first metal member containing any of aluminum, an aluminum alloy, copper, or a copper alloy to form a second stacked body; and
a second joining step of sintering the first joining material by heating the second stacked body while pressing the second stacked body in a stacking direction to form a first sintered copper layer, thereby joining the first intermediate metal layer and the first metal member by the first sintered copper layer.

10. The method for manufacturing a multilayer assembly according to claim 9,
wherein the first metal member contains aluminum or an aluminum alloy,
in the intermediate metal layer forming step, a second intermediate metal layer containing any of copper, nickel, silver, or gold is further formed on one surface of the first metal member, and
in the second joining step, the second intermediate metal layer is joined to the first sintered copper layer.

11. The method for manufacturing a multilayer assembly according to claim 9,
wherein a plurality of groove portions are formed on the surface of the first aluminum plate opposite to the ceramic substrate before the first stacking step.

12. The method for manufacturing a multilayer assembly according to any one of claims 9 to 11,
wherein in the first stacking step, a brazing material and a second aluminum plate containing aluminum or an aluminum alloy are further stacked on the other surface of the ceramic substrate to form the first stacked body, and
in the first joining step, by pressing and heating the first stacked body including the second aluminum plate, the first aluminum plate is joined to the one surface of the ceramic substrate and the second aluminum plate is joined to the other surface to form the first assembly.

13. The method for manufacturing a multilayer assembly according to claim 12,
wherein in the intermediate metal layer forming step, a third intermediate metal layer containing any of copper, nickel, silver, or gold is further formed on a surface of the second aluminum plate of the first assembly opposite to the ceramic substrate,
in the second stacking step, a second joining material formed into a sheet shape with a plurality of copper particles bound by a binder and a second metal member containing any of aluminum, an aluminum alloy, copper, or a copper alloy are sequentially further stacked on the third intermediate metal layer to form the second stacked body, and
in the second joining step, a second sintered copper layer is further formed by sintering the second joining material to join the third intermediate metal layer and the second metal member by the second sintered copper layer.

14. The method for manufacturing a multilayer assembly according to claim 13,
wherein the second metal member contains aluminum or an aluminum alloy,
in the intermediate metal layer forming step, a fourth intermediate metal layer containing any of copper, nickel, silver, or gold is further formed on one surface of the second metal member, and
in the second joining step, the fourth intermediate metal layer is joined to the second sintered copper layer.

15. A method for manufacturing a semiconductor device using the method for manufacturing a multilayer assembly according to claim 12,
wherein after the second joining step,
a mounting step of mounting an electronic component on the first metal member and connecting a lead frame to the electronic component, and
a resin sealing step of sealing the electronic component with an insulating resin in a state in which a tip portion of the lead frame and at least a surface of the second aluminum plate opposite to the ceramic substrate are exposed from the insulating resin are further included.

16. A method for manufacturing a semiconductor device using the method for manufacturing a multilayer assembly according to claim 12,
wherein between the intermediate metal layer forming step and the second stacking step,
a mounting step of mounting an electronic component on the second aluminum plate and connecting a lead frame to the electronic component, and
a resin sealing step of sealing the electronic component with an insulating resin in a state in which a tip portion of the lead frame and at least a surface of the first intermediate metal layer are exposed from the insulating resin are further included.

17. A method for manufacturing a semiconductor device using the method for manufacturing a multilayer assembly according to claim 12,
wherein in the intermediate metal layer forming step, a third intermediate metal layer containing any of copper, nickel, silver, or gold is further formed on a surface of the second aluminum plate of the first assembly opposite to the ceramic substrate, and
after the second joining step,
a mounting step of mounting an electronic component on the first metal member and connecting a lead frame to the electronic component,
a resin sealing step of sealing the electronic component with an insulating resin in a state in which a tip portion of the lead frame and at least a surface of the third intermediate metal layer are exposed from the insulating resin,
a third stacking step of sequentially further stacking a second joining material formed into a sheet shape with a plurality of copper particles bound by a binder and a second metal member containing any of aluminum, an aluminum alloy, copper, or a copper alloy on the third intermediate metal layer to form a third stacked body, and
a third joining step of sintering the second joining material by heating the third stacked body while pressing the third stacked body in a stacking direction to form a second sintered copper layer, thereby joining the third intermediate metal layer and the second metal member by the second sintered copper layer are further included.
